# EUROPEAN PATENT APPLICATION

(11) **EP 2 442 247 A2**
(43) Date of publication of application: **18.04.2012**
(21) Application number: 11182890.1
(22) Date of filing: 27.09.2011
(51) Int. Cl.: G06F 17/50

(54) **Custom physics simulation joints**

(30) Priority: 27.09.2010 US 386745 P; 21.09.2011 US 238402
(71) Applicant: Siemens Corporation, Iselin, NJ 08830 (US)
(72) Inventor: McDaniel, Richard Gary, Highstown, NJ 08520 (US)
(74) Representative: Wheatley, Alison Clare

(57) **Abstract**

A computer-implemented method of simulating a physical system includes accessing (20) a representation of the physical system, the representation defining a joint relationship between first and second rigid body objects, the joint relationship being specified via an instantiation of a class, the class instantiation being representative of a parameter of the joint relationship. The method further includes implementing (22), with a processor, a function of the parameter class instantiation, the function being operable to return a characteristic of an axis of the joint relationship, constraining (24), with the processor, the joint relationship based on the returned axis characteristic, and maintaining (26) the representation of the physical system in accordance with the constrained joint relationship.

## Description

### CROSS-REFERENCE TO RELATED APPLICATION

This application claims the benefit of U. S. provisional application entitled "Using Callback Methods to Provide Custom Joints in a Physics Engine," filed September 27, 2010, and assigned Serial No. 61/386,745, the entire disclosure of which is hereby incorporated by reference.

### BACKGROUND

The present embodiments relate to simulating physical systems involving rigid body dynamics.

A physics engine is a computer-implemented system that models or simulates the motion of a physical system under the action of physical laws. A physics engine is capable of simulating gravity, elasticity, and/or the conservation of momentum between interacting objects. Physics engines use variables, such as mass, position, velocity, and external forces, in performing the simulation. Physics engines may perform rigid body simulation, fluid simulation, cloth simulation, and other physical processes.

Physics engines are used in simulations for computer animation and artificial intelligence. Physics engines can respond to a user's input in a video game to provide a satisfying representation of an interaction in a substantially real or imagined world for a user. Physics engine simulations are also used to model manufacturing and other operational environments. To these ends, simulation systems often include an application programming interface (API) or a software development kit (SDK) for communication with, and control of, the physics engine.

In rigid body simulation, the constraints that hold the bodies together are called joints. A physics engine SDK typically supports a limited number of types of joints, such as basic rotary and linear connectors. Each joint is usually specified by a number of fixed parameters. These parameters are typically vectors, location points, floating point numbers, or Boolean values.

Some rigid body physics engine SDKs allow a user to create completely custom constraints for a joint. However, these constraints are specified through custom code in a low-level programming language, such as C++, and may thus be more difficult to use.

### SUMMARY

By way of introduction, the embodiments described below include methods, systems, and computer program products for simulating physical systems via custom joints between rigid bodies. Joints between the rigid bodies may be simulated using joint constraints created via functions of a class that forms a framework for specifying joint relationships.

In a first aspect, a computer-implemented method of simulating a physical system includes accessing a representation of the physical system. The representation defines a joint relationship between first and second rigid body objects. The joint relationship is specified via an instantiation of a class, the class instantiation being representative of a parameter of the joint relationship. The method further includes implementing, with a processor, a function of the parameter class instantiation, the function being operable to return a characteristic of an axis of the joint relationship, constraining, with the processor, the joint relationship based on the returned axis characteristic, and maintaining the representation of the physical system in accordance with the constrained joint relationship.

In a second aspect, a system simulates a joint relationship between first and second rigid body objects. The system includes a memory in which parameter data for the joint relationship is stored. The parameter data includes an instantiation of a class representative of a parameter of the joint relationship, the class instantiation specifying a function operable to return a state of an axis of the joint relationship. The system further includes one or more processors in communication with the memory, configured to implement the function and generate a constraint for the joint relationship based on the returned axis state, and further configured to maintain a representation of the first and second rigid body objects in accordance with the constraint for the joint relationship.

In a third aspect, a non-transitory computer program product includes a computer-readable medium encoded with computer-readable instructions that, when executed by a processing system, direct the processing system to receive a representation of a physical system with a joint relationship between first and second rigid body objects, implement a function of a class with parameters of the joint relationship, the function being operable to return a state of an axis of the joint relationship, generate a constraint for the joint relationship based on the returned axis state, and maintain the representation of the physical system in accordance with the generated constraint.

The present invention is defined by the following claims, and nothing in this section should be taken as a limitation on those claims. Further aspects and advantages of the invention are discussed below in conjunction with the preferred embodiments and may be later claimed independently or in combination.

### BRIEF DESCRIPTION OF THE DRAWINGS

The components and the figures are not necessarily to scale, emphasis instead being placed upon illustrating the principles of the invention. Moreover, in the figures, like reference numerals designate corresponding parts throughout the different views.

Figure 1 is a flow diagram of an example embodiment of a method of simulating a physical system with a parameter class-based joint constraint.

Figure 2 is a flow diagram of an example embodiment of a method of obtaining data to create an instantiation of a parameter class to support the simulation method of Figure 1.

Figure 3 is a block diagram of an example embodiment of a simulation system for implementing the methods of Figures 1 and 2.

Figure 4 is an object diagram of an example parameter class framework stored in a physics library or other memory of the simulation system of Figure 3.

Figure 5 is an example user interface for specifying data to create a joint based on a parameter class in accordance with one embodiment.

Figure 6 is an example of a simulation of a physical system rendered via one embodiment in accordance with a single-axis constraint.

Figure 7 is an example of a simulation of a physical system rendered via one embodiment in accordance with a dual-axis constraint.

Figure 8 depicts a block diagram of a system configured for implementation of a simulation with a parameter class-based joint constraint.

### DETAILED DESCRIPTION OF THE PRESENTLY PREFERRED EMBODIMENTS

Methods, systems, and computer-readable storage media are provided for simulation of a physical system involving rigid body dynamics. The systems may include a rigid body constraint solver configured in accordance with the disclosed methods to create and manage a joint relationship to simulate a joint between rigid bodies. The joint relationship may be specified with one or more parameters via a class-based framework, e.g., an instantiation of a virtual class, determinative of the behavior or other characteristic(s) of the joint. Use of a class to specify parameters of the joint relationship may allow new and more complex constrained behavior to be simulated, such as gear, cam, speed, and positioning operations.

The parameter class may support the creation of constraint relationships that use non-fixed, multi-dimensional, or other data sources or relationships that depend upon another variable or aspect of the physical system. The simulation may thus include one or more constraints on the joint relationship based on the other variable or aspect of the physical system. The data indicative of the variable or aspect of the physical system may be specified via tables, graphs, or other multi-dimensional data structures or arrangements. Such non-fixed parameterization may allow a user to generate constraints between bodies that may be otherwise unavailable given a software development kit (SDK), application programming interface (API), or other interface of a physics engine or other simulation system.

The data structures and operational components of the parameter class may provide a framework for creating joint relationships that avoids forcing a user to create a custom joint via low-level code on a joint-by-joint basis. The invention may provide customization both at a low-level with the definition of an axis state class, and also at a user level via a position table or other data structure that instantiates the axis state class.

The methods and systems may provide new kinds of constraints to control a single axis as well as to control multiple (e.g., pairs of) axes in a physical system in tandem. The methods and systems may thus implement controlled positioning for single and pairs of rotary and linear joints. These kinds of joints may be used to implement positioning motors, gear, cams, and other kinds of behavior found in mechanical devices.

Although described below in connection with simulation or modeling of production machines, the disclosed methods, systems, and computer program products are not limited to any particular physical system, simulation context, or physics engine or simulator. For example, the disclosed methods may be applied in the context of computer-aided design (CAD), computer animation (e.g., rendering graphics for a video game), or in a variety of dynamic system modeling contexts. The nature, purpose, and other characteristics of the physical system being simulated may vary from the examples described and shown. Use of the disclosed methods is not limited to any particular physics engine or simulation system, insofar as the disclosed methods may be incorporated into any one of several different commercially available physics engines (e.g., PhysX from NVIDIA Corporation, and Bullet Physics via AMD).

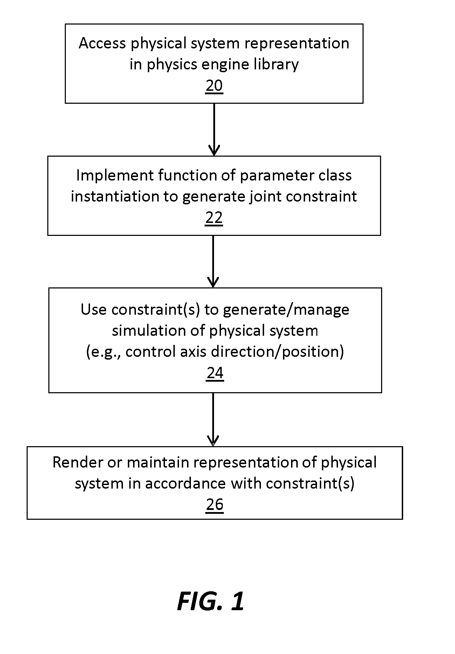

Figure 1 depicts a computer-implemented method of simulating a physical system. The method may be implemented on any one or more of the processors or processing systems described below, or another processor. The computer implementing the method may include any number of computing devices, e.g., workstations or other computers, processors, processing systems, or other hardware integrated or in communication with one another to any desired extent. The hardware configuration of the computer implementing the method may vary from the examples described below. The method may be implemented as part of a physics engine or other simulation system, examples of which are described below.

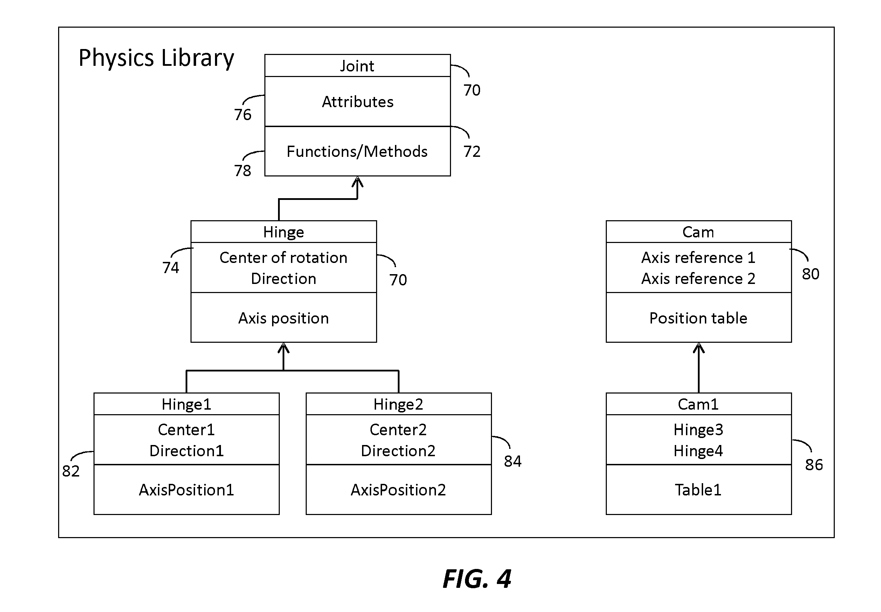

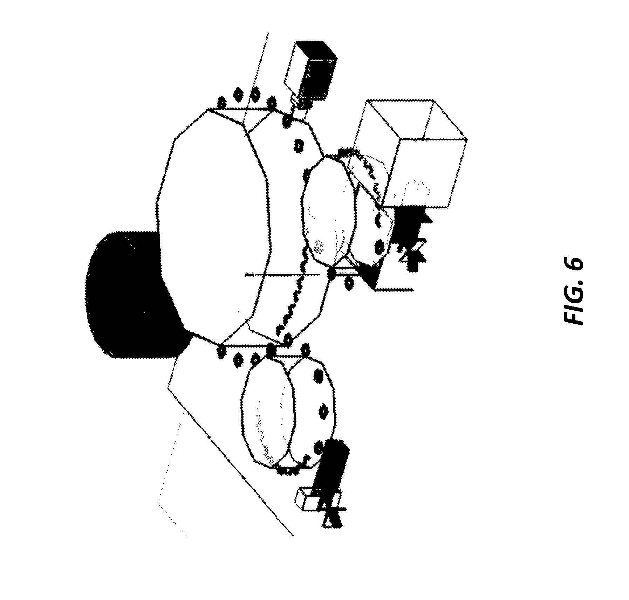

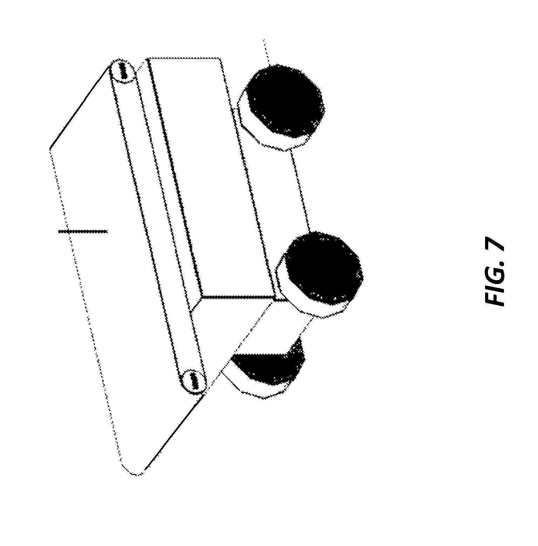

The computer-implemented method may begin in act 20 by accessing a representation of the physical system. The representation defines a joint relationship between first and second rigid body objects. Examples of physical systems having joints between rigid body objects are shown in Figures 6 and 7. Figure 6 shows cam constraints for grippers in a bottling plant, and Figure 7 shows rotary joints for rollers on a conveyor belt. In conjunction with the predefined joints provided in a physics library of the physics engine to constrain such joints, the representation relies on a custom joint or constraint type that provides a template, framework, or basis for specifying the attributes, details, or other aspects of the joint relationships. Data representative of the template may be stored in the physics library in conjunction with the predefined joint types (see, for example, Figure 4), or in any other memory in communication with the simulation system.

The joint relationship is specified via an instantiation of a class. The class provides the framework or template for customizing the joint relationship. The class may, for instance, be associated with a specific type of joint by, for instance, physical structure (e.g., a hinge joint), or more broadly by any other characteristic (e.g., single-axis constraint). Creating an instance of the class, or instantiation, defines a specific joint relationship for the physical system being simulated. By specifying the details called for by the class, each instantiation of the class includes data representative of the joint relationship and/or one or more parameters of the joint relationship. Parameters may include both attributes of the joint relationship (e.g., position, angle, etc.) and methods or functions configured to represent the operational behavior (e.g., movement, timing, etc.) of the joint relationship. As described below, the class may be a virtual class, which may allow one or more attributes or methods of the class of a higher class to be redefined via the instantiation.

The parameters specified via the class provide one or more constraints on the joint relationship during simulation of the physical system. Given an instantiation of the class for a specific joint relationship, the method implements in act 22 one or more functions of the parameter class instantiation. Each function is operable to return a state or other characteristic of an axis of the joint relationship. The function may return a value used to constrain the joint relationship. For example, one method of a class may be configured to return the direction of the axis. Another method may be configured to return the current position of the axis. One or more of the methods may be configured as callback methods. The methods may thus include one or more references to a data source(s) to support the implementation of the methods. The methods may thus rely on user-specified data to define custom joint behavior not limited to predefined vectors and values. In instantiating the class, the methods may be overridden by user-specified data. In this way, the simulation methods are not limited to defining a joint relationship with, for instance, only a fixed algorithm for determining axis direction. Further details regarding examples of the functions to be specified via the parameter classes are provided below.

The axis state or other characteristic(s) returned by the function(s) of the class instantiation are used in act 24 to constrain the joint relationship during the simulation. The behavior of the joint constraint is based on the returned axis characteristic(s). For example, the axis of the joint relationship may be oriented, positioned, or otherwise controlled via the data returned by the function(s) or method(s) of the class. Constraining the joint relationship may thus, for example, control a position or direction of an axis of the joint relationship.

The functions or methods may be used to manage or control a joint relationship characterized by a single axis, or the axis may be one of multiple (e.g., a pair) axes of the joint relationship. A custom single axis control parameter may be made available that changes the direction of the axis dynamically. The simulation system may use this parameter to create positioning control data. In one example, such control data may be useful for paths that curve and twist and otherwise do not maintain a single direction. The single axis control parameter may be representative of a linear or rotary joint. Examples of such common axis joints are the hinge joint, the sliding joint, and the cylindrical joint. For a cylindrical joint, either the rotary or the linear aspect of the position can be controlled.

The function or method of the class may also be used to manage or control a joint relationship characterized by more than one axis, such as a dual-axis constraint relationship. In a multiple axis context, each axis may be defined by a respective axis state determined by the methods or functions of the class. The constraint(s) of the joint relationship may be parameterized with two axis state classes, one for each joint. As in a gear example described below, each axis of a pair of axes of a joint relationship may be managed or otherwise controlled based on the axis state of the other axis of the pair of axes. The simulation system may thus manage two axes simultaneously. In some embodiments, the system may use the position of each axis to control the other axis. The system may use these types of parameter constraints to implement gear and cam constraints. A gear may cause two objects to turn or slide in proportion to one another's change in position. For example, a rotary gear may be used to cause one body to turn twice as fast as a second body.

With the data for the joint relationship determined, the simulation system may render, update, or otherwise maintain in act 26 the representation of the physical system in accordance with the constrained joint relationship. The representation may be a data representation of the physical system. The representation may be rendered by a computer or other processor or processing system in communication with the physics engine or other processor or processing system implementing the other acts of Figure 1, as described in the examples below.

In some embodiments, the simulation system is configured such that the parameters of the joint relationship are specified via a virtual class. A virtual class is a class that possesses at least one virtual method. The implementation of a virtual class may be customized to be different for different subclasses of a base class. Thus, a generic system may be customized, insofar as the class calls the virtual method generically, resulting in different effects for different kinds of objects.

The virtual class may define an axis as an entity that has direction and position. The virtual methods may return a vector, such as direction, and a scalar, such as position. Use of a virtual class allows one to implement the meaning of "axis" differently for different kinds of joints. For example, a rotary joint defines position as an angle, and a linear joint defines position as an offset. The constraint for maintaining an axis relationship, such as a cam, may thus be implemented generically for any axis joint, whether the joint is linear, rotary, a curve, spline, etc. The framework provided by the virtual class may avoid having to make different implementations of, for example, a pair of rotary joints and a pair of linear joints, or one of each.

As described above, the virtual class has one or more functions or methods that the user may override for returning the state of an axis, which may be used to manage or constrain the current position or direction of one or more axes of the joint relationship. Implementation of the methods of the virtual class generates a virtual axis state based on a position table (see example below) or other data set. In a single axis control context, the data set may, for instance, control the position of the axis joint over time. In a dual axis control context, the data set may also use a position table to constrain the positions of two bodies using a relationship stored in the table. For example, a cam constraint may displace a slave axis at a position dictated by a master axis. Such cam constraints may pair any combination of linear and rotary axes.

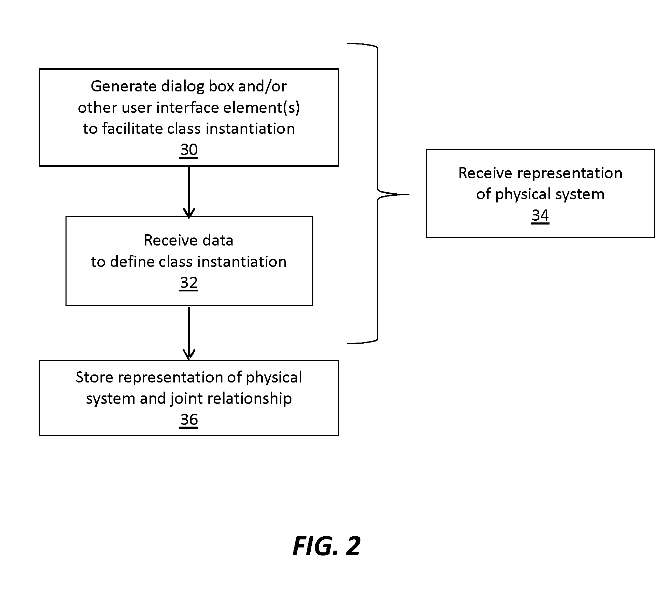

Figure 2 depicts one example of a class instantiation method in which the custom joints are defined or specified prior to simulation. Data representative of attributes and other aspects of each joint is received and stored to specify the parameters, or the data underlying the parameters, of each joint relationship. The data that leads to the joint constraints is thus not fixed or embedded in low-level code executed by the physics engine. The data may instead be entered by a user via one or more user interfaces for receipt and storage by the simulation system.

In this example, a dialog box or other user interface element(s) may be generated in act 30 to facilitate the class instantiation for a particular joint relationship. The dialog box may be generated in response to a selection of the joint in a rendering of the physical system, or in response to any other user request or command. The application programming interface (API) or software development kit (SDK) of the physics engine or simulation system may be used to support such requests or commands, as well as the generation of the user interface elements.

The user interface may enable a user to enter the data as a relationship between a control variable and a dependent variable. The data may include corresponding sets of data values for the control and dependent variables. In one example, the system allows the user to enter time varying and position dependent data into constraints using a tabular graph. The graph may thus have two axes.

Alternatively or additionally, the user interface may enable the user to create a table of values showing how the dependent axis' value should depend on the control axis. The table may be a table of position data, i.e., a position table. For example, position tables that have a control axis set for rotary or linear values may be used in cam constraints. Tables with a time control axis may be used in single axis speed or position control. The user interface is not limited to tables or tabular graphs. Any data arrangement or structure may be used.

Upon completing the data entry via the user interface(s), the simulation system receives the data in act 32 to define the interpretation of the parameter class in the joint relationship to be used in the constraint relationship. Such data entry and class instantiation may constitute part of a broader process 34 in which the representation of the physical system is received by the physics engine or simulation system. The representation of the physical system, including the joint and constraint relationships thereof, are then stored in act 36 using one or more memories or storage devices. The storage location may be a physics repository or other library accessed by the physics engine. These data collection and storage acts may, but need not, be implemented within the physics engine, and may by implemented by one or more processors or processing systems integrated with the processor(s) of the physics engine to any desired extent.

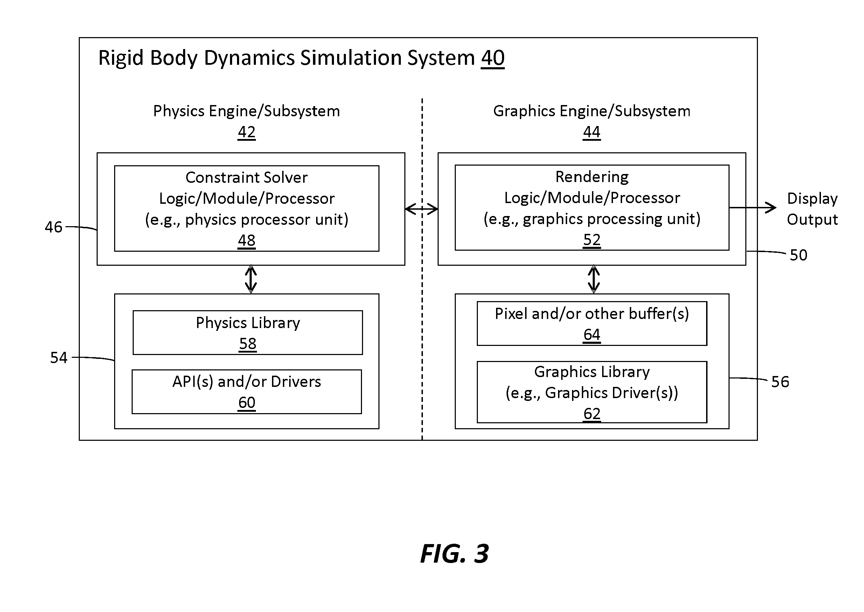

Figure 3 depicts a system 40 for simulating a joint relationship between first and second rigid body objects in accordance with the above-described methods. The system 40 may include a physics engine or subsystem 42 and a graphics engine or subsystem 44. The subsystems 42, 44 may be integrated to any desired extent, and may share one or more processors or processing systems and one or more memories or storage devices. In this example, the physics engine or subsystem 42 includes a processing system 46 which includes a constraint solver 48 that may be configured to generate the joint constraints and other aspects of the simulation as described herein. The processing system 46 may include a software module or other logic for generating the joints and other constraints. The processing system 46 may include a physics processing unit (PPU) dedicated to executing such software or logic. The graphics engine or subsystem 44 may include a processing system 50 for rendering the representation of the physical system generated by the physics engine 42. The processing system 50 may include a rendering processor, module or other logic 52 in communication with the PPU or other components of the physics engine 42. The rendering processor 52 may include one or more graphics processing units (GPU). The processing system 50 provides the rendered representation to one or more display output devices.

The simulation system 40 includes one or more memories or storage devices in communication with the processing systems. In this example, the subsystems 42, 44 have respective memories (or storage architectures) 54, 56. The memory 54 of the physics engine or subsystem 42 may store the parameter data for the joint relationship, including the parameter data indicative of an instantiation of a class or virtual class. Such data may be representative of a parameter of the joint relationship by specifying a function operable to return a state of an axis of the joint relationship, as described herein. The constraint solver 48 is in communication with the memory 54 to implement the function and generate a constraint for the joint relationship based on the returned axis state. The memory 54 may include a physics library 58 in which the parameter data is stored along with data indicative of the rigid bodies constrained by the joint relationship, as well as other joint types used in the simulation. The parameter data may be stored in the physics library 58 in any data structure or arrangement, including in a structure having corresponding sets of data values for control variables and dependent variables, as described below. The memory 54 may also store data or information representative of one or more APIs or other drivers 60 for the physics engine 42.

The physics library 58 may store data indicative of variables used in implementing the methods or functions of the joint relationships. The data may specify an axis state or characteristic based on a variety of control variables, such as time, or rotary or linear position of another axis of the joint relationship, or the position of one of the rigid body objects constrained by the joint relationship. The data stored in the physics library 58 may then include data representative of the corresponding dependent variable in the joint relationship, such as a rotary or linear position of an axis of the joint relationship.

The rendering processor 52 may be configured via drivers and other data stored in a graphics library 62 of the memory 56. The rendering processor 52 may use pixel or other data buffers 64 of the memory 56 in rendering the representation of the physical system. The configuration of the memories 54, 56 may vary from the example shown, and may include any number of storage devices of varying construction and type.

Figure 4 depicts one example of the data and information stored in the physics library or other memory of the simulation system to specify the joint relationship(s) for the simulation. The data is specified as instances of one or more joint or other constraint classes. In this example, a joint class 70 includes a single template joint class 72 under which one or more joint type classes 74 may be created to support a variety of different joint types (e.g., hinge, etc.). The joint class 70 may have one or more attributes 76 and one or more functions or methods 78. For the hinge joint class 74, the attributes may be direction and center of rotation of the joint, and an axis position function may be specified that calculates the angular difference between the objects attached by the hinge. One or more constraint classes and constraint type classes may be provided for constraints (e.g., a cam, etc.) between joints. In this example, a cam constraint class 80 includes attributes that reference a pair of axis joints (e.g., a hinge) and a position table to specify the relationship between the pair of joints.

The attributes of a joint may include references to the pair of rigid bodies to which the joint connects. A rigid body may have attributes of mass, inertia tensor, velocity, angular velocity, position, and orientation. A hinge is one kind of joint and may have parameters in addition to those specifying the rigid bodies to which the hinge connects, such as an axis of rotation and a position for its center of rotation. An axis state object may be attached to the hinge to maintain its position during simulation execution. A cam may have references to two axis joints as attributes as well as a position table to specify the relation the axis joints will follow.

Figure 4 depicts the physics library in a class or object diagram to show several instantiations of the joint and constraint classes. In this example, two instantiations 82, 84 of the joint classes 70, named Hinge1 and Hinge2, are of the hinge-type joint, while one instantiation 86, named Cam1, is of the cam-type constraint. Each hinge joint is configured via specified values for direction and center and via the data underlying the axis position function. In this example, the position of the axis is evaluated by obtaining the orientation of the rigid bodies attached by the hinge, which may be representative of a rotary position of the joint relationship or of either one of the first and second rigid body objects. In an alternative example, the constraint used to control the axis position is representative of time. The dependent variable (the output of the axis function or method) may correspond with a rotary or linear value. Rotary values may be represented by angle values in degrees or radians. Linear values may be distances in meters or inches.

In the cam constraint, one axis (e.g., Axis Reference 1) is controlled via a function of the position of the other axis (e.g., Axis Reference 2). The Cam1 instantiation 86 of the cam constraint class 80 includes data in a position table, Table 1, and references to two joints, Hinge3 and Hinge4.

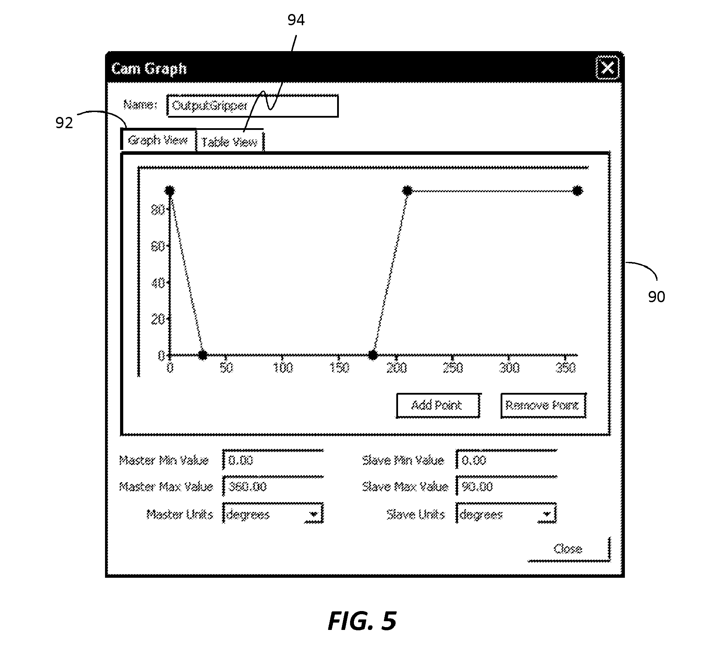

Figure 5 depicts one example of a user interface generated by the disclosed simulation system to collect the data used to specify the parameters of a joint relationship via instantiation of one of the joint classes. In this example, the user interface includes a dialog box 90 having a tabs 92, 94 to allow a user to access a graph view and a table view of the data. The graph view is selected to reveal a graphical plot of the data, which includes a relationship between a dependent variable plotted along the y axis and a control variable plotted along the x axis. In this example, the control variable is measured in degrees, ranging from 0-360 degrees, and the dependent variable is also measured in degrees, ranging from 0-90 degrees. Data points on the graphical plot may be added by the user, and the ranges and units of the variables may be specified via text entry boxes. Selection of the table view tab 94 may present the same data in a tabular arrangement, and allow the user to make similar adjustments to the nature or other characteristics of the variables.

The data shown in the example of Figure 5 may be used as a position table for a rotary joint axis of a dual-axis constraint relationship for a cam constraint. The rotary position of one axis, the control variable, may be determinative of the rotary position of another axis, the dependent variable, and vice versa. This relationship may be used to define cam behavior. Other examples of position or other data tables may specify a single-axis constraint relationship. For example, the table data may determine the speed of a wheel axis turned by a motor, thereby allowing the speed to vary over time. A custom constraint may thus be created for a physical system to be simulated, which may provide a better representation than joints in the physics engine library having only a fixed speed.

Figures 6 and 7 depict examples of physical systems represented via the simulation systems and methods described above. Figure 6 shows a bottling plant example having a number of grippers that open and close based on a state of an axis specifying the behavior of each gripper. Figure 7 shows a cart with a conveyor belt and two sets of wheels. The conveyor belt includes a pair of rollers, each having an axis that may be constrained via parameters derived from the class-based techniques described above. The turning of the wheels may be specified as a dual-axis constraint relationship as described above so that all of the wheels turn at the same rate.

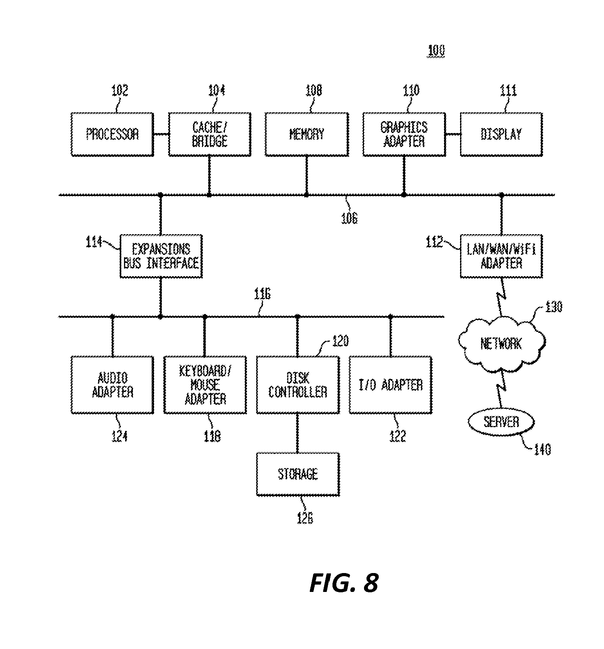

Figure 8 depicts a block diagram of a data processing system 100 in which an embodiment of the above-described simulation systems may be implemented, for example as a CAD or PLM system configured to perform processes as described herein. The data processing system 100 includes a processor 102 connected to a level two cache/bridge 104, which is connected to a local system bus 106. The local system bus 106 may be, for example, a peripheral component interconnect (PCI) architecture bus. Also connected to the local system bus 106 are a main memory 108 and a graphics adapter 110. The graphics adapter 110 may be connected to a display 111.

Various peripherals, such as local area network (LAN)/Wide Area Network/Wireless (e.g. WiFi) adapter 112, may also be connected to the local system bus 106. An expansion bus interface 114 connects the local system bus 106 to an input/output (I/O) bus 116. The I/O bus 116 is connected to a keyboard/mouse adapter 118, a disk controller 120, and an I/O adapter 122. A disk controller 120 may be connected to a memory or storage device 126, which include any one or more suitable machine usable or machine readable storage media, including but not limited to nonvolatile, hard-coded type media such as read only memories (ROMs) or erasable, electrically programmable read only memories (EEPROMs), magnetic tape storage, and user-recordable type mediums such as disk drives and compact disk read only memories (CD-ROMs) or digital versatile disks (DVDs), and other known optical, electrical, or magnetic storage devices.

Also connected to the I/O bus 116 is an audio adapter 124, to which speakers (not shown) may be connected for playing sounds. A keyboard/mouse adapter 118 provides a connection for a selection device (not shown), such as a mouse, trackball, touchpad, etc.

The hardware components may vary from the example shown. For example, other or additional peripheral devices, such as an optical disk drive and the like, may be used. The depicted example is not intended to specify any architectural limitations with respect to the implementation of the above-described simulation methods and systems.

The LAN/WAN/Wireless adapter 112 may be connected to a network 130, which may be any public or private data processing system network or combination of networks, including the Internet. The processing system 100 may communicate over the network 130 with a server system 140, which may be implemented as part of the data processing system 100, or as a separate data processing system.

The above-described methods and systems may be implanted via a non-transitory computer program product. The computer program product may be stored on any one or more of the aforementioned memories or storage devices, or on any other computer-readable medium. The computer-readable medium is encoded with computer-readable instructions that, when executed by any one or more of the aforementioned processing systems or any other processing system, direct the processing system to receive a representation of a physical system with a joint relationship between first and second rigid body objects, implement a function of a parameter class of the joint relationship, the function being operable to return a state of an axis of the joint relationship, generate a constraint for the joint relationship based on the returned axis state, and render the representation of the physical system in accordance with the generated constraint. The parameter class may be a virtual class, the virtual class being specified via a callback method overridden by user-specified data that defines an instantiation of the parameter class.

The methods and systems described above may be used to provide and support new types of constraints and joints that would normally not be available for constraining bodies in a rigid body solver. Such new constraints and joints may be used to control object positions in ways that are useful for mechanical engineers and the simulation of production machines.

While the invention has been described above by reference to various embodiments, it should be understood that many changes and modifications may be made without departing from the scope of the invention. It is therefore intended that the foregoing detailed description be regarded as illustrative rather than limiting, and that it be understood that it is the following claims, including all equivalents, that are intended to define the spirit and scope of this invention.

## Claims

1. A computer-implemented method of simulating a physical system, the computer-implemented method comprising:
accessing (20) a representation of the physical system, the representation defining a joint relationship between first and second rigid body objects, the joint relationship being specified via an instantiation of a class, the class instantiation being representative of a parameter of the joint relationship;
implementing (22), with a processor, a function of the parameter class instantiation, the function being operable to return a characteristic of an axis of the joint relationship;
constraining (24), with the processor, the joint relationship based on the returned axis characteristic; and
maintaining (26) the representation of the physical system in accordance with the constrained joint relationship.

2. The computer-implemented method of claim 1, further comprising receiving (32) data to define the instantiation of the parameter class for the joint relationship.

3. The computer-implemented method of claim 2, further comprising generating (30) an interface for a user to enter the data as a relationship between a control variable and a dependent variable, wherein the data comprises corresponding sets of data values for the control and dependent variables.

4. The computer-implemented method of claim 3, wherein the control variable is representative of a rotary or linear position of the joint relationship or of either one of the first and second rigid body objects.

5. The computer-implemented method of claim 3, wherein the control variable is representative of time.

6. The computer-implemented method of claim 3, wherein the dependent variable is representative of a rotary or linear position of the joint relationship.

7. The computer-implemented method of claim 1, wherein:
the axis of the joint relationship is one of a pair of axes of the physical system, each axis of the pair of axes being defined by a respective axis state; and
constraining the joint relationship comprises managing one axis of the pair of axes based on the axis state of the other axis of the pair of axes.

8. The computer-implemented method of claim 1, wherein constraining the joint relationship comprises controlling a position of the axis.

9. The computer-implemented method of claim 1, wherein constraining the joint relationship comprises controlling a direction of the axis.

10. The computer-implemented method of claim 1, wherein the parameter class is a virtual class, the virtual class being specified via a callback method overridden by user-specified data that defines the instantiation of the parameter class.

11. A system (40) for simulating a joint relationship between first and second rigid body objects, the system comprising:
a memory (54) in which parameter data for the joint relationship is stored, the parameter data comprising an instantiation of a class representative of a parameter of the joint relationship, the class instantiation specifying a function operable to return a state of an axis of the joint relationship;
one or more processors (46, 50) in communication with the memory (54), configured to implement the function and generate a constraint for the joint relationship based on the returned axis state, and further configured to maintain a representation of the first and second rigid body objects in accordance with the constraint for the joint relationship.

12. The system (40) of claim 11, wherein the memory (54) comprises a physics library (58) in which the parameter data is stored, and wherein the parameter data comprises corresponding sets of data values for control variables and dependent variables.

13. The system (40) of claim 12, wherein the control variable is representative of a rotary or linear position of the joint relationship or of either one of the first and second rigid body objects.

14. The system (40) of claim 12, wherein the control variable is representative of time.

15. The system (40) of claim 12, wherein the dependent variable is representative of a rotary or linear position of the joint relationship.

16. The system (40) of claim 12, wherein:
the axis of the joint relationship is one of a pair of axes of the joint relationship, each axis of the pair of axes being defined by a respective axis state; and
the one or more processors (46, 50) are further configured to manage one axis of the pair of axes based on the axis state of the other axis of the pair of axes.

17. The system (40) of claim 11, wherein the constraint controls a position of the axis.

18. The system (40) of claim 11, wherein the constraint controls a direction of the axis.

19. The system (40) of claim 11, wherein the parameter class is a virtual class, the virtual class being specified via a callback method overridden by user-specified data that defines the instantiation of the parameter class.

20. A non-transitory computer program product comprising a computer-readable medium encoded with computer-readable instructions that, when executed by a processing system, direct the processing system to:
access (20) a representation of a physical system with a joint relationship between first and second rigid body objects;
implement (22) a function of a class with parameters of the joint relationship, the function being operable to return a state of an axis of the joint relationship;
generate (24) a constraint for the joint relationship based on the returned axis state; and
maintain (26) the representation of the physical system in accordance with the generated constraint.

21. The non-transitory computer program product of claim 20, wherein the class is a virtual class, the virtual class being specified via a callback method overridden by user-specified data that defines an instantiation of the parameter class.
